(19) Europäisches Patentamt
European Patent Office
Office européen des brevets

(11) **EP 2 227 832 B1**

(12) **EUROPÄISCHE PATENTSCHRIFT**

(45) Veröffentlichungstag und Bekanntmachung des Hinweises auf die Patenterteilung:
**09.03.2016 Patentblatt 2016/10**

(21) Anmeldenummer: **08856139.4**

(22) Anmeldetag: **04.12.2008**

(51) Int Cl.:
**H01L 31/054** (2014.01)

(86) Internationale Anmeldenummer:
**PCT/EP2008/010302**

(87) Internationale Veröffentlichungsnummer:
**WO 2009/071300 (11.06.2009 Gazette 2009/24)**

(54) **PHOTOVOLTAIK-VORRICHTUNG UND DEREN VERWENDUNG**

PHOTOVOLTAIC DEVICE AND USE THEREOF

DISPOSITIF PHOTOVOLTAÏQUE ET SON UTILISATION

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **07.12.2007 DE 102007058971**

(43) Veröffentlichungstag der Anmeldung:
**15.09.2010 Patentblatt 2010/37**

(73) Patentinhaber:
• **Fraunhofer-Gesellschaft zur Förderung der angewandten Forschung e.V.**
**80686 München (DE)**
• **Albert-Ludwigs-Universität Freiburg**
**79085 Freiburg (DE)**

(72) Erfinder:
• **GOETZBERGER, Adolf**
**79249 Merzhausen (DE)**
• **GOLDSCHMIDT, Jan Christoph**
**79100 Freiburg (DE)**
• **LÖPER, Philipp**
**79110 Freiburg (DE)**
• **PETERS, Marius**
**79110 Freiburg (DE)**

(56) Entgegenhaltungen:
WO-A-2007/044996    WO-A1-00/74147
JP-A- 2002 198 556   US-A- 4 418 238
US-A- 4 960 468      US-A- 5 291 331
US-A1- 2003 213 514  US-A1- 2006 191 566

**Beschreibung**

Die Erfindung betrifft eine Photovoltaik-Vorrichtung zur direkten Umwandlung von Sonnenenergie in elektrische Energie, die eine Lichtfalle zur Konzentrierung von Sonnenlicht aufweist, die mit den Solarzellen gekoppelt ist. In der erfindungsgemäßen Lichtfalle wird dabei durch Reflexion oder Streuung diffuse Strahlung erzeugt.

Der Wirkungsgrad einer Solarzelle, die nur aus einem Halbleitermaterial besteht, ist theoretisch auf maximal etwa 30 % begrenzt. Maximal erreicht man heute im Labor mit Silizium knapp 25 %. Um höhere Wirkungsgrade zu erreichen, ist es notwendig, das Sonnenspektrum in Fraktionen aufzuteilen und mit unterschiedlichen Solarzellen umzuwandeln. Das geschieht nach heutigem Stand der Technik durch Multigap-Stapelzellen. Sie bestehen aus aufeinander gestapelten Solarzellen mit verschiedenen Bandabständen. Die oberste Solarzelle hat den höchsten Bandabstand und absorbiert den kurzwelligen Teil des Sonnenspektrums, ist aber transparent für den Rest der Strahlung, die von darunter liegenden Solarzellen umgewandelt wird. Die besten dieser Stapelzellen werden aus III-V-Verbindungen durch Gasphasenepitaxie hergestellt. Material und Herstellung sind sehr aufwändig, so dass diese Zellen nur in Konzentratorsystemen Verwendung finden. Wirkungsgrade bis zu 40 % wurden damit erreicht.

Das Prinzip der Stapelzelle wird auch bei Dünnschichtzellen eingesetzt, z.B. bei amorphem Silizium, das durch Zusatz von Ge oder C in seiner Bandlücke variiert werden kann.

Auch Tandemzellen aus amorphem Silizium und mikrokristallinem Silizium werden heute schon gefertigt. Die Wirkungsgrade der Dünnschichtzellen liegen aber bei Stapelzellen deutlich unter denen der marktbeherrschenden Zellen aus mono- oder multikristallinem Silizium. Allen Stapelzellen gemeinsam sind folgende Probleme:

- Alle Solarzellen des Stapels müssen genau den gleichen Strom erzeugen, da der Stapel eine Serienschaltung darstellt, was in der Praxis heute noch nicht möglich ist.
- Zwischen den einzelnen Solarzellen muss eine Tunneldiode eingefügt werden, da sonst die Polarität der Zellen nicht stimmen würde.
- Eine Änderung der spektralen Verteilung des Sonnenlichts kann zur Veränderung der Stromflüsse in den Zellen und damit zu einer Verringerung des Wirkungsgrads führen.

Ein erster Ansatz zur Beseitigung dieser Nachteile beruht auf der Verwendung einer Kavität. US 5,291,331 A beschreibt eine solche Kavität, der Sonnenlicht mittels eines Konzentrators zugeführt werden kann. Auch US 2003/0213514 beschreibt eine solche Kavität. In der Kavität sind Solarzellen mit verschiedenen Bandabständen angeordnet. Das Sonnenlicht ist in der Kavität gefangen und kann reflektiert werden bis es von einer Solarzelle mit entsprechenden spektralen Absorptionseigenschaften absorbiert wird.

Die US 5,291,331 und die US 2003/0213514 offenbaren also eine Photovoltaik-Vorrichtung zur direkten Umwandlung von Sonnenenergie in elektrische Energie enthaltend eine Lichtfalle sowie mindestens eine mit der Lichtfalle gekoppelte Solarzelle, wobei die Lichtfalle an der dem Sonnenlicht zugewandten Seite mindestens eine Lichteintrittsfläche zur Einkopplung von Sonnenlicht in die Lichtfalle aufweist, sowie mindestens eine Vorrichtung zur diffusen Reflexion oder Streuung des in die Lichtfalle eingekoppelten Sonnenlichts und mindestens eine das reflektierte und/oder gestreute Sonnenlicht reflektierende Struktur, die einen Austritt des reflektierten und/oder gestreuten Sonnenlichts im wesentlichen verhindern, enthält.

Ein weiterer Ansatz zur Beseitigung der oben dargestellten Nachteile beruht auf der spektralen Aufteilung des Sonnenlichts. Dabei wird das Sonnenlicht zunächst in seine spektralen Bestandteile zerlegt und fällt dann erst auf einzelne Solarzellen, die auf den jeweiligen Wellenlängenbereich optimiert sind. Die spektrale Aufteilung von Sonnenlicht wurde bereits untersucht und verschiedene Verfahren hierzu vorgestellt (A.G. Imenes, D.R. Mills, Solar Energy Materials & Solar Cells 19, (2004), S. 84 ff.).

Ausgehend hiervon war es Aufgabe der vorliegenden Erfindung, eine Photovoltaik-Vorrichtung zur direkten Umwandlung von Sonnenenergie in elektrische Energie bereitzustellen, die die beschriebenen Nachteile des Standes der Technik beseitigt und eine effiziente Konzentrierung von Sonnenlicht ermöglicht.

Diese Aufgabe wird durch die Photovoltaik-Vorrichtung mit den Merkmalen des Anspruchs 1 gelöst. Die weiteren abhängigen Ansprüche zeigen vorteilhafte Weiterbildungen auf. Anspruch 19 nennt eine erfindungsgemäße Verwendung.

Erfindungsgemäß wird eine Photovoltaik-Vorrichtung zur direkten Umwandlung von Sonnenenergie in elektrische Energie bereitgestellt, die eine Lichtfalle sowie mindestens eine mit der Lichtfalle gekoppelte Solarzelle enthält. Die Lichtfalle weist dabei an der dem Sonnenlicht zugewandten Seite mindestens eine Lichteintrittsfläche zur Einkopplung von Sonnenlicht auf. Ebenso enthält die Lichtfalle mindestens eine Vorrichtung zur diffusen Reflexion oder Streuung des in die Lichtfalle eingekoppelten Sonnenlichts und mindestens eine das reflektierte und/oder gestreute Sonnenlicht reflektierende Struktur, die einen Austritt des reflektierten und/oder gestreuten Sonnenlichts im Wesentlichen verhindert.

Unter Vorrichtung zur diffusen Reflexion oder Streuung ist im Rahmen der vorliegenden Erfindung auch eine Vorrichtung zur streuenden Einkopplung zu verstehen.

Die Erfindung basiert somit auf der Einkopplung von Sonnenlicht in eine Lichtfalle, in der das einfallende Sonnenlicht dann in diffuse Strahlung umgewandelt wird. Die thermodynamische Theorie von Yablonovitch (E. Yablonovitch, J. Opt. Soc. Am. 899, Vol. 72, 1982) beruht darauf, dass diffuses Licht in einem brechenden Medium mit einem Brechungsindex n um den Faktor $2n^2$ im Vergleich zur Lichtintensität im Außenraum verstärkt wird. Die Strahlung muss hierzu in der Lichtfalle reflektiert bzw. gestreut werden.

Erfindungswesentlich ist es weiterhin, dass durch die eingeschränkte Austrittsmöglichkeit des Lichts aus der erfindungsgemäßen Lichtfalle die Lichtintensität im Inneren der Lichtfalle weiter erhöht werden kann.

Eine Ausführungsform sieht vor, dass an der Lichteintrittsfläche der Lichtfalle mindestens eine photonische Struktur angeordnet ist, die winkelselektive Reflexions- und Transmissionseigenschaften besitzt. Ihre Eigenschaften sind so gewählt, dass das direkte Sonnenlicht für den im Wesentlichen gesamten Sonnenlauf eingekoppelt wird, insbesondere in Kombination mit einer zumindest teilweisen Nachführung der Photovoltaikvorrichtung nach dem Sonnenlauf. Bei einer vollständigen Nachführung kann der Akzeptanzbereich auf einen Raumwinkel eingeschränkt werden, der dem Raumwinkel entspricht, unter dem die Sonne auf der Sonne sichtbar ist. Dieser entspricht einem Kegel mit einem Öffnungswinkel von 0.27°.

Es ist dabei bevorzugt, dass die Lichtfalle wesentlich kleiner als die Fokussierungsvorrichtung ist, da auf diese Weise der Kostenaufwand für die von den optischen Komponenten kostenaufwändige Lichtfalle reduziert werden können, ohne wesentliche Einbußen hinsichtlich der Effizienz der Lichtfalle zu erleiden. Ebenso wird so ermöglicht, dass Lichtfallen mit geringem Gewicht eingesetzt werden können. Wegen des geringen Volumens der Lichtfalle ist es auch möglich, die Lichtfalle aus einem Material mit hohem Brechungsindex herzustellen, welches normalerweise sehr kostenaufwändig ist.

In diesem Fall ist es besonders bevorzugt, wenn die gesamte Oberfläche der Solarzellen, d.h. die der Sonne zugewandte und abgewandte Fläche ebenso wie die seitlichen Flächen mit Solarzellen belegt werden, wobei nur die Lichteintrittsfläche frei bleibt. Es können so Reflexionsverluste vermieden werden.

Es ist weiter bevorzugt, dass an der dem Sonnenlicht abgewandten Fläche, an der dem Sonnenlicht zugewandten Fläche und/oder an den seitlichen Flächen der Lichtfalle zumindest bereichsweise Solarzellen angeordnet sind. In den Bereichen der Flächen der Lichtfalle, in denen keine Solarzellen angeordnet sind, sind dann vorzugsweise Reflektoren oder lichtstreuende Elemente zumindest bereichsweise angeordnet. Bevorzugt sind die Reflektoren und lichtstreuenden Elemente dabei in Form von Beschichtungen angeordnet.

Es können Solarzellen aus unterschiedlichen Materialien eingesetzt werden, z.B. auch Dünnschicht-Solarzellen.

Vorzugsweise weisen die Solarzellen eine Rückseitenkontaktierung auf. Dies kann dadurch ermöglicht werden, dass die sog. Wrap-through-Technik eingesetzt wird. Dann sind alle Kontakte auf der Rückseite und die Frontseite wird nicht durch Kontaktbahnen abgedeckt. Dieses Prinzip ist allerdings nur auf Einfach-Solarzellen anwendbar.

Vorzugsweise ist die der Lichtfalle zugewandte Oberfläche der mindestens einen Solarzelle gleich oder kleiner als die seitlichen Flächen der Lichtfalle.

Ein weiterer wichtiger Aspekt der vorliegenden Erfindung betrifft den Einsatz von mindestens zwei Solarzellen aus Halbleitermaterialien mit unterschiedlichen Bandabständen. Die Solarzellen bestehen somit aus verschiedenen Halbleitermaterialien, die jeweils einen Teil des Sonnenspektrums optimal umwandeln.

Die selektive Umwandlung der Strahlung des Sonnenspektrums kann durch die erfindungsgemäße Verwendung von spektral selektiven Filtern realisiert werden, die nur den für die Solarzellen optimalen Spektralbereich passieren lassen und den Rest der Sonnenstrahlung reflektieren.

Eine weitere Variante sieht vor, dass die Solarzelle, die für den kurzwelligsten Bereich des Sonnenspektrums selektiv ist, an der Rückseite einen Spiegel zur Reflexion von Strahlung der weiteren Spektralbereiche aufweist. Auf diese Weise kann die Zahl der optischen Filter reduziert werden, indem man die Eigenschaft der Halbleiter ausnutzt, für Lichtwellenlängen unterhalb der Bandkante transparent zu sein. Es genügt somit für die Solarzelle mit dem höchsten Bandabstand, auf der Rückseite dieser Solarzelle einen Reflektor anzubringen. Dies hat die praktische Auswirkung, dass bei drei Solarzellen aus verschiedenen Halbleitern nur für zwei Solarzellen ein Filter erforderlich ist, wofür z.B. ein Kantenfilter eingesetzt werden kann.

Der Einsatz von Solarzellen aus unterschiedlichen Halbleitermaterialien in Kombination mit spektral selektiven Filtern bringt folgende Vorteile mit sich:

- Jede Solarzelle kann separat optimiert werden und aus verschiedenen Halbleitermaterialien bestehen, die Notwendigkeit der Kristallgitteranpassung entfällt.

- Die einzelnen Solarzellen müssen nicht den exakt gleichen Strom erzeugen, wie es bei der Serienschaltung von Stapelzellen erforderlich ist.

- Es kann auf die technisch aufwändige Tunneldiode, wie sie von Stapelzellen bekannt ist, verzichtet werden.

- Das System ist unabhängig von Änderungen der spektralen Verteilung der Strahlung, sofern die Solarzellen für die verschiedenen Spektralbereiche separat kontaktiert werden.

- Neben diesen technologischen Vorteilen können durch die bessere Optimierbarkeit der Photovoltaik-Vorrichtung auch höhere Wirkungsgrade in Bezug auf die Umwandlung von Sonnenenergie in elektrische Energie erreicht werden.

Ebenso ist es bevorzugt, dass an der Lichtfalle vereinfachte Stapelzellen angebracht werden. So kann durch die Anordnung von drei Tandemzellen eine Aufteilung des Spektrums in sechs Bereiche erfolgen.

Es ist weiterhin bevorzugt, dass der Lichtfläche zugewandte Oberfläche der Solarzelle größer als die Lichteintrittsfläche ist. Auf diese Weise kann ein hoher Wirkungsgrad der Photovoltaik-Vorrichtung erzielt werden. In diesem Fall erfolgt also eine Konzentration des Sonnenlichts gefolgt von einer Dekonzentration. Insgesamt ist aber immer noch ein hoher Konzentrationsfaktor gegeben.

Im Hinblick auf die Bandpassfilter ist es in bestimmten Situationen angestrebt, die Zahl derartiger Filter zu minimieren, insbesondere wenn sie scharfe Kanten haben sollen, da diese aus einer Vielzahl dielektrischer Schichten bestehen und daher kostenaufwändig herzustellen sind. Eine Möglichkeit, die Zahl der Filter zu reduzieren, besteht darin, dass die Frontseite, d.h. die dem Licht zugewandte Seite der Lichtfalle, mit einer hochenergetischen, d.h. kurzwelligen, Solarzelle abgedeckt wird. Dabei wird kurzwelliges Licht durch diese Solarzelle umgewandelt, so dass bereits gefiltertes Licht in die Lichtfalle eintritt und man auf einen Filter verzichten kann. Die Funktion der Lichtfalle wird dadurch nicht beeinträchtigt. Allerdings wird die Lichtkonzentration in der Solarzelle erhöht, da sie einen hohen Brechungsindex hat. Sie muss daher eine Transparenz für längerwelliges Licht aufweisen.

Eine andere Möglichkeit zur Reduzierung der Anzahl von Filtern besteht darin, dass in einer Lichtfalle auf der dem Sonnenlicht abgewandten Fläche der Lichtfalle eine Solarzelle angeordnet ist. Durch die Brechung an der Oberfläche der Lichtfalle fällt ein großer Winkelbereich des einfallenden Lichts auf diese Solarzelle. Die Solarzelle hat auf der Rückseite einen diffusen Reflektor bzw. eine raue Oberfläche. Bei Zweiteilung des Spektrums bracht man hier dann keinen weiteren Filter.

Die erfindungsgemäße Photovoltaik-Vorrichtung lässt sich für stationäre, schwach konzentrierende Kollektoren anwenden, wenn eine geringe Lichtkonzentration akzeptabel ist. Hierbei kann dann ein Teil der diffusen Strahlung eingekoppelt werden.

Ebenso ist es möglich, die erfindungsgemäße Photovoltaik-Vorrichtung auf nicht winkelselektive, rein stationäre Systeme anzuwenden, die auch für Zonen mit diffusem Licht geeignet sind. Im Unterschied zu herkömmlichen Solarzellen verwendet man hier die verschiedenen Solarzellentypen, die mit entsprechenden Filtern abgedeckt sind, nebeneinander. Bei Aufteilung in zwei Fraktionen, die hier optimal ist, ergibt sich ohne Dekonzentration ein Wirkungsgrad von 0,69, was relativ niedrig ist. Für höhere Wirkungsgrade kann man eine echte Dekonzentration heranziehen. Hierfür gibt es verschiedene bevorzugte Anordnungen, z.B. Schindeln, Sägezahn, Quader oder Balken. In all diesen Anordnungen ist die bestrahlte Fläche kleiner als die Solarzellenfläche. Diese Konfigurationen eignen sich daher insbesondere für Dünnschicht-Solarzellen.

Besonders bevorzugt sind Anordnungen als Sägezahn oder Balken. Bei einem 45°-Sägezahn ist das Verhältnis der Solarzellenfläche $A_s$ zur Lichteintrittsfläche $A_i$ 1,41. Für ein zweigeteiltes Sonnenspektrum ist dann $\eta_F$ 0,86. Dünnschicht-Solarzellen können dabei von beiden Seiten auf dem gekippten Sägezahn aufgedampft werden.

Bei der balkenartigen Anordnung ist $A_s/A_i$ gleich 1,5 und $\eta_F$ gleich 0,87. Die Anordnung kann dabei folgendermaßen realisiert werden. Viele Einzelbalken werden parallel nebeneinander gepackt und gleichzeitig beschichtet. Dann werden sie um 90° bzw. 180° rotiert und erneut beschichtet. Anschließend werden sie mit den freien Seiten nach oben in ein Modul eingesetzt.

Sowohl bei der Anordnung in Sägezahnform bzw. Balkenform können die Zellen üblicherweise in Reihenschaltung verbunden und die Anschlüsse nach außen herausgeführt werden.

Der Wirkungsgrad der erfindungsgemäßen Photovoltaik-Vorrichtung lässt sich drastisch erhöhen, wenn man in einem System die beiden beschriebenen Konzepte der geometrischen, verkleinerten Lichtfalle mit den photonischen Strukturen kombiniert. In der Praxis ist die in die Lichtfalle eingekoppelte konzentrierte Strahlung nicht isotrop, wie theoretisch angenommen, sondern durch die Geometrie der Abbildung durch Fresnel-Linsenwinkel begrenzt. Der Öffnungswinkel einer aus dem Stand der Technik bekannten Flatcon-Struktur beträgt 16,45°. Auf der Oberfläche der Lichtfalle kann nun eine photonische Struktur mit diesem Akzeptanzwinkel aufgebracht werden. Somit geht keine Strahlung verloren, da sie auf diesen Winkel begrenzt ist. Andererseits wird dadurch die Lichtintensität im Inneren der Lichtfalle stark erhöht und damit der Wirkungsgrad der Lichtfalle ebenso. Die Lichtintensität im Inneren der Lichtfalle lässt sich dabei nach folgender Formel berechnen:

$$I_{\text{int}} = \frac{I_{inc}}{\sin(\theta)^2} 2n^2$$

Mit $\theta$ = 16,45 erhält man ($I_{int}/I_{inc}$ = 55,79.

Anhand der nachfolgenden Figuren soll der erfindungsgemäße Gegenstand näher erläutert werden, ohne sich auf die hier gezeigten speziellen Ausführungsformen einschränken zu wollen.

Fig. 1 zeigt eine nicht erfindungsgemäße Photovoltaik-Vorrichtung.

Fig. 2 zeigt ein Diagramm zur Abhängigkeit des Wirkungsgrades von der Solarzellenfläche und der Lichteintrittsfläche.

Fig. 3 zeigt eine weitere nicht erfindungsgemäße Photovoltaik-Vorrichtung.

Fig. 4 zeigt eine erfindungsgemäße Photovoltaik-Vorrichtung mit photonischen Strukturen.

Fig. 5 zeigt eine weitere erfindungsgemäße Photovoltaik-Vorrichtung mit Streuzentren.

Fig. 6 zeigt eine weitere erfindungsgemäße Photovoltaik-Vorrichtung mit Streuschicht und Reflektor.

Fig. 7 zeigt eine weitere erfindungsgemäße Photovoltaik-Vorrichtung mit Reflektoren, die über einen Luftspalt beabstandet sind.

Fig. 8 zeigt Beispiele für Anordnungen der erfindungsgemäßen Photovoltaik-Vorrichtung.

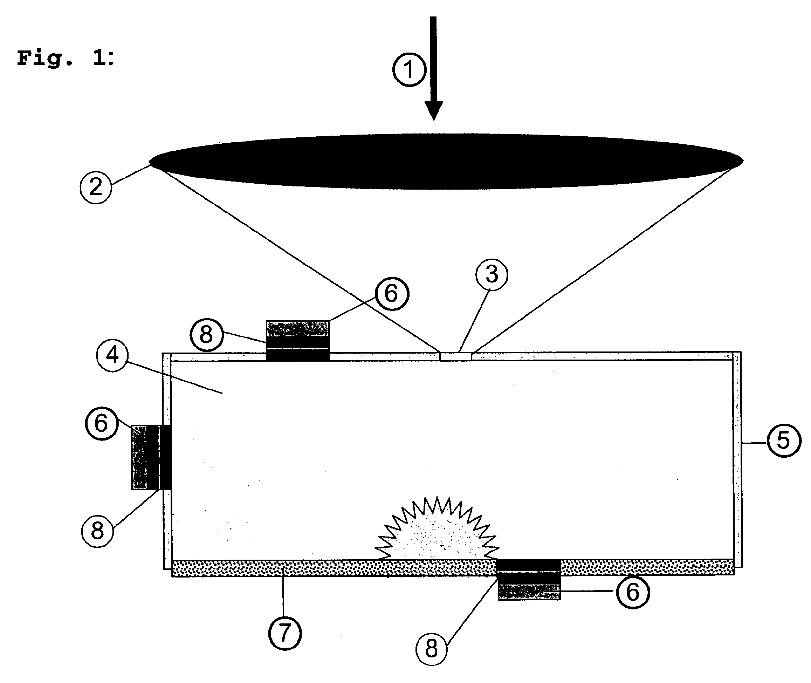

In Fig. 1 ist ein nicht erfindungsgemäßes konzentrierendes, der Sonne nachgeführtes System dargestellt. Das Sonnenlicht 1 wird hier durch eine Linse bzw. Spiegel 2 konzentriert. Die konzentrierte Solarstrahlung gelangt durch eine nicht erfindungsgemäße Apertur 3 in die Lichtfalle 4, deren Oberfläche teilweise mit Reflektoren 5 und optisch angekoppelten Solarzellen 6 bedeckt ist. Die Bedeckung der Oberfläche sorgt dafür, dass das Licht in der Lichtfalle verbleibt und Verluste nur durch einen Austritt durch die Apertur auftreten können. Dabei ist es notwendig, dass das Licht eine Diffusion erfährt. In Fig. 1 wird dies über einen diffusen Reflektor 7 an der Rückseite erreicht, es sind jedoch auch andere Mechanismen möglich. An der Apertur 3 tritt ein Sprung der Lichtintensität um den Faktor $2n^2$ auf. Die Solarzellen bestehen aus verschiedenen Halbleitermaterialien, die jeweils einen Teil des Sonnenspektrums optimal umwandeln. Gleichzeitig sind an der Grenzfläche zwischen Solarzellen und Lichtfalle wellenlängenabhängige Bandpassfilter 8 angebracht, die nur den für die Solarzellen optimalen Spektralbereich passieren lassen, den Rest aber reflektieren.

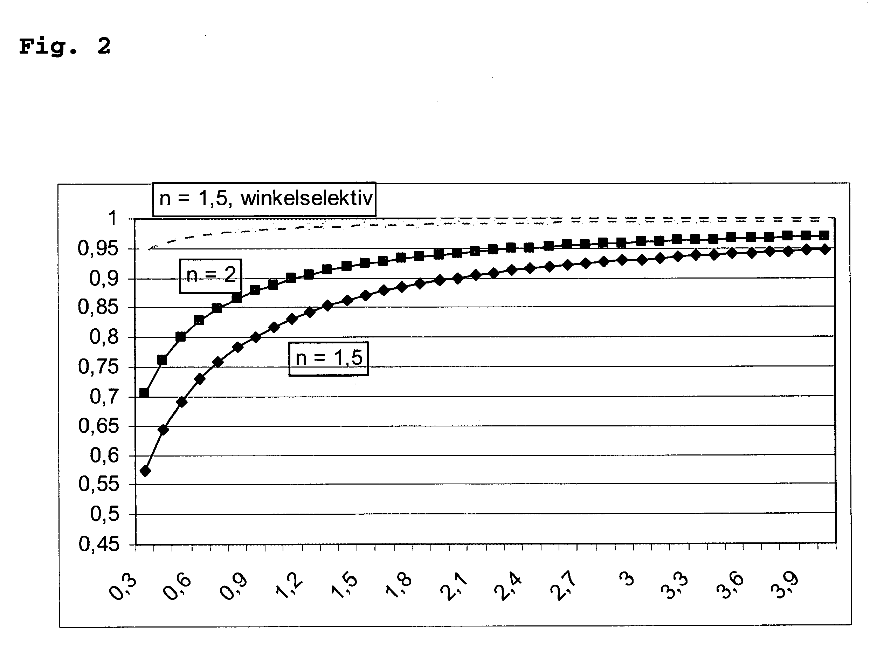

In Fig. 2 wird der Zusammenhang zwischen dem Wirkungsgrad der Photovoltaik-Vorrichtung und dem Verhältnis von Solarzellenfläche zu Lichteintrittsfläche für Brechungsindizes 1,5 und 2,0 dargestellt. Der Wirkungsgrad der nicht erfindungsgemäßen Photovoltaik-Vorrichtung lässt sich wie folgt bestimmen. Der durch die nicht erfindungsgemäße Apertur, d.h. Lichteintrittsfläche, bedingte Intensitätsverlust beträgt $I_{int}A_i/2n^2$, wobei $I_{ist}$ die Lichtintensität im Inneren der Lichtfalle und $A_i$ die Lichteintrittsfläche bedeuten. Vorausgesetzt wird hier, dass die Lichtintensität innerhalb der Lichtfalle homogen ist. Das durch die Solarzellen, die optisch direkt an die Lichtfalle angekoppelt sind, absorbierte Licht ist der Fläche $A_s$ der Solarzellen direkt proportional: $A_sI_{int}$. Der Wirkungsgrad der Lichtfalle unter Voraussetzung idealer, auch selektiver Reflektoren beträgt dann

$$\eta_F = A_sI_{int}/(A_sI_{int} + I_{int}A_i/2n^2).$$

Hierbei ist zu berücksichtigen, dass die nicht erfindungsgemäße Lichtfalle sehr klein sein darf und trotzdem einen guten Wirkungsgrad besitzen kann. Die Gesamtfläche der Solarzellen hängt von der Unterteilung des Sonnenspektrums ab. Der in Fig. 2 dargestellte Wirkungsgrad gilt somit für jeden Spektralbereich separat, d.h. für z.B. drei Spektralbereiche ist insgesamt die dreifache Solarzellenfläche erforderlich. Im Falle einer würfelförmigen Lichtfalle, deren Oberfläche Eintrittsfläche ist und deren Seiten- und Grundflächen mit Solarzellen bedeckt sind, bedeutet dies, dass die Gesamtsolarzellenfläche dann $5a^2$ beträgt, wenn a die Kantenlänge ist. Der Wirkungsgrad ist dann mit $A_s/A_i = 5/3 = 1{,}67$, somit 0,882. In diesem Fall ist es sehr leicht, eine gleichförmige Strahlungsverteilung in der Lichtfalle zu erzielen. Auch schwache Lichtabsorption in der Lichtfalle kann toleriert werden.

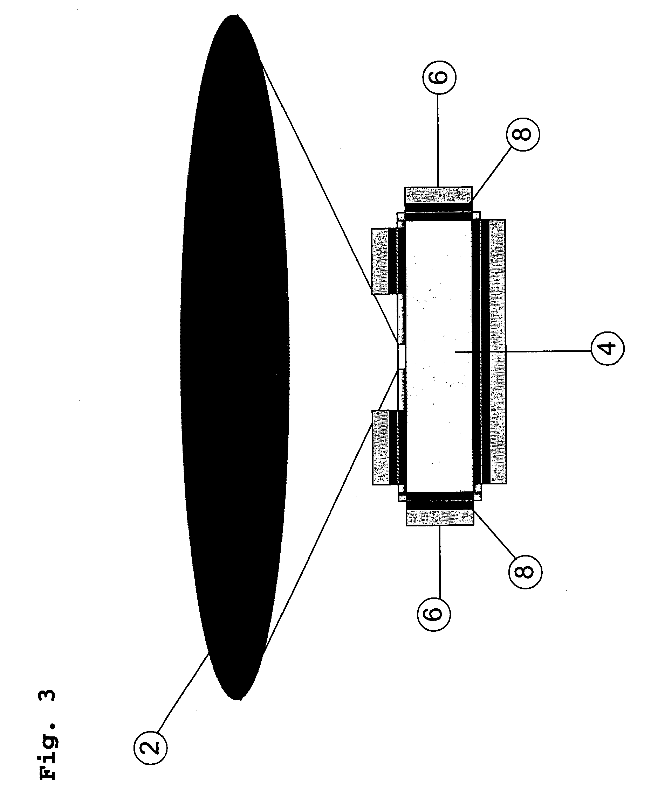

Fig. 3 zeigt anhand einer schematischen Darstellung einer nicht erfindungsgemäßen Vorrichtung aus einer Linse bzw. einem Spiegel 2, gekoppelt mit einer Lichtfalle 4. Hierbei ist die Dimension der Linse bzw. des Spiegels deutlich größer als die der Lichtfalle. An der Lichtfalle ist hier eine Vielzahl von Solarzellen 6 in Kombination mit Bandpassfiltern 8 angeordnet.

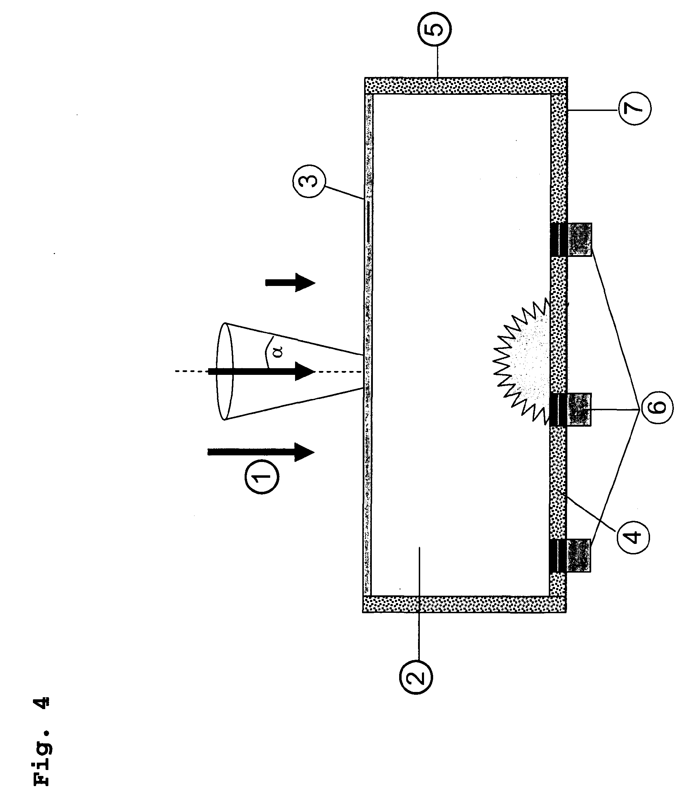

In Fig. 4 ist eine Ausführungsform der erfindungsgemäßen Photovoltaik-Vorrichtung dargestellt, die auf einer winkelselektiven photonischen Struktur basiert. Die photonische Struktur 3 ist dabei für einen definierten Winkelbereich im Wesentlichen transparent, während andere Winkelbereiche reflektiert werden. Fig. 4 zeigt die einfallende Sonnenstrahlung 1, die in die Lichtfalle 2, die aus einem Medium hoher Transparenz, z.B. Glas oder Plastik, besteht, einfällt. Die photonische Struktur 3 stellt hier einen winkelselektiven Filter mit einem Öffnungswinkel $\alpha$ dar. Nur Strahlung innerhalb dieses Winkels kann in die Lichtfalle gelangen. Für die Funktion der erfindungsgemäßen Lichtfalle ist es wichtig, dass auch aus dem Inneren der Lichtfalle nur Strahlen in diesen engen Öffnungswinkel (modifiziert durch den Brechungsindex) entkommen können. Alle anderen Winkel werden zurückreflektiert. Des Weiteren befinden sich auf der Rückseite und an den seitlichen Flächen der Lichtfalle diffuse Reflektoren 4, die die ankommende Strahlung gleichmäßig in alle Richtungen reflektieren. Der diffuse Reflektor sollte ein möglichst hohes Reflexionsvermögen haben, da das Licht sehr oft an den Grenzflächen reflektiert wird, um hohe Lichtkonzentrationen zu erreichen.

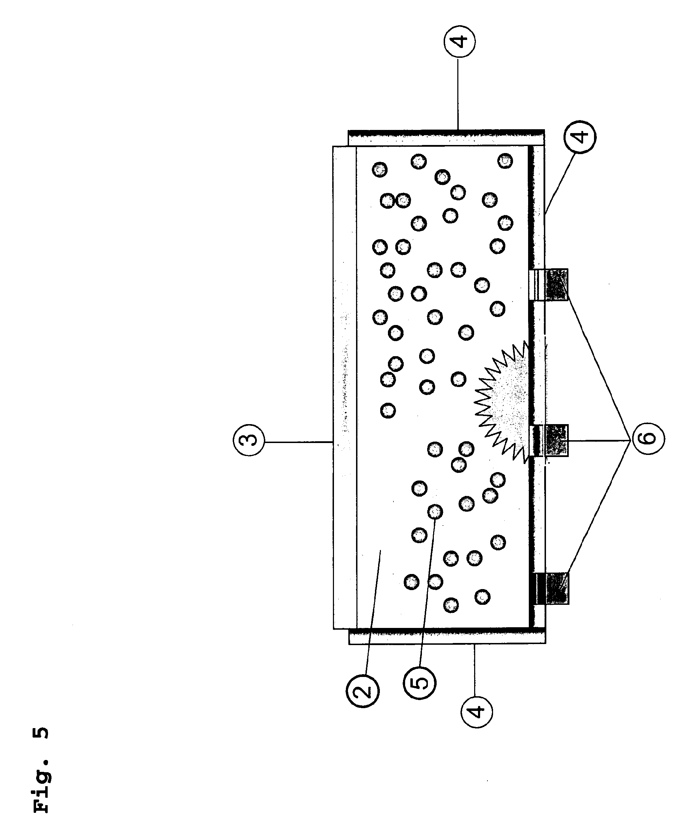

In Fig. 5 ist eine erfindungsgemäße Vorrichtung dargestellt, die im Inneren der Lichtfalle gleichmäßig verteilte Streuzentren 5 aufweist. Die Streuzentren können sowohl zur Verstärkung der Diffusion des Lichts durch die Reflektoren 4 an den Seiten der Lichtfalle verwendet werden, als auch als alleinige Erzeuger der diffusen Strahlung dienen. Dabei ist es wichtig, dass die Streuzentren möglichst wenig Absorption verursachen. Das Innere der Lichtfalle ist von diffuser Strahlung erfüllt. Auf der Rückseite der Lichtfalle 2 befinden sich gleichmäßig verteilt Solarzellen 6 mit den entsprechenden spektralselektiven Filtern 7. Die Fläche der Lichtfalle 2 in Beziehung gesetzt zur Gesamtfläche der Solarzellen ergibt das Maß für die geometrische Konzentration.

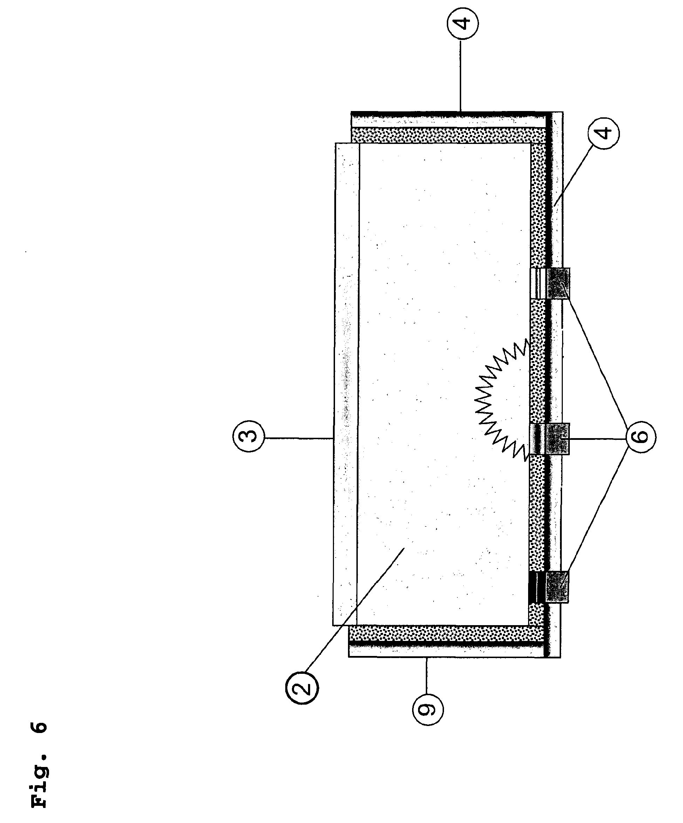

Fig. 6 zeigt eine weitere Variante der erfindungsgemäßen Vorrichtung, wobei ein hoher Reflexionskoeffizient dadurch erreicht wird, dass zusätzlich zu einer streuenden Schicht 4 ein ebener Spiegel 9 auf der Rückseite sowie optional auch an den seitlichen Flächen angebracht ist. Der Spiegel kann hier auch eine photonische Struktur darstellen.

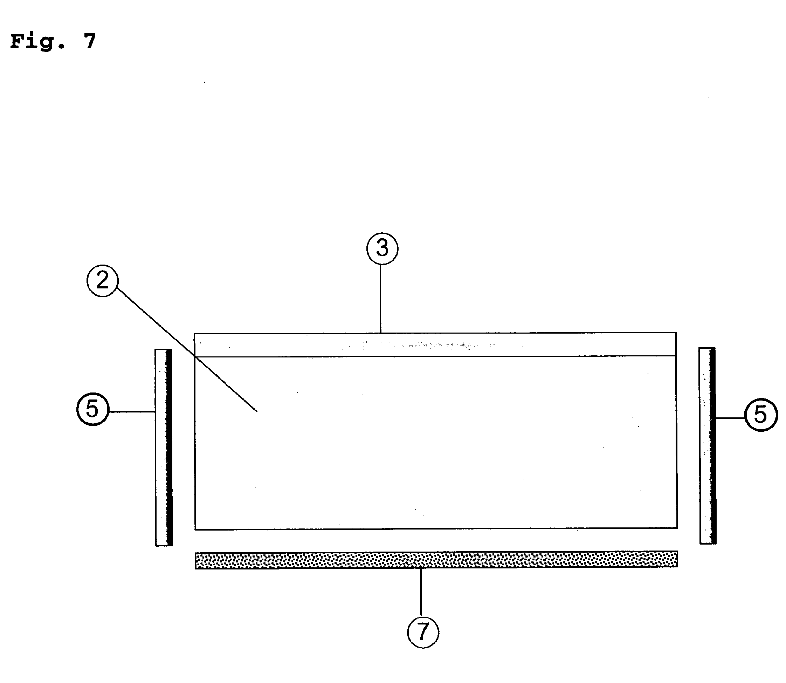

Fig. 7 zeigt eine weitere erfindungsgemäße Variante mit hoher Reflektivität. In einem geringen Abstand, z.B. einem Luftspalt, von der Oberfläche der Lichtfalle 2, der die Totalreflexion nicht behindert, sind weiße Reflektoren 7 oder Spiegel mit hohem Reflexionsgrad 5 angeordnet. Der größte Teil des Lichts, etwa 78 % für eine Oberfläche, wird dann durch Totalreflexion in der Falle zurückgehalten. In diesem Fall ist die Totalreflexion verlustfrei, da nicht total reflektiertes Streulicht außen von den Reflektoren zurückreflektiert werden kann. So lassen sich äußerst hohe Gesamtreflexionsfaktoren erreichen. Der Reflexionsfaktor ist dann für eine Seite der Lichtfalle L/2(1-R), wobei L der Verlust durch den Totalreflexionskegel und R der diffuse Reflexionsfaktor der Abdeckung bedeutet. Für R = 0,98 und L = 0,22 ergibt sich $R_{Ges}$ = 0,9965.

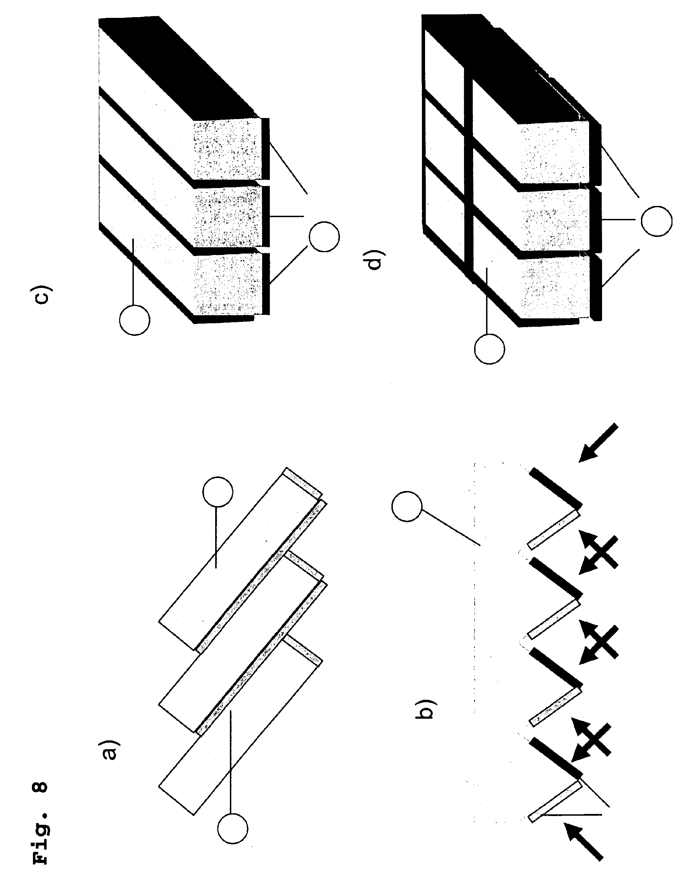

In Fig. 8 sind verschiedene Anordnungsmöglichkeiten für die erfindungsgemäße Photovoltaik-Vorrichtung aufgezeigt. Hierbei handelt es sich um Schindeln, Sägezähne, Quader bzw. Balken. In allen dargestellten Beispielen ist die bestrahlte Fläche kleiner als die Solarzellenfläche. Diese Strukturen eignen sich besonders für geringe Konzentrationen o der selektiven Kollektoren.

**Patentansprüche**

1. Photovoltaik-Vorrichtung zur direkten Umwandlung von Sonnenenergie in elektrische Energie enthaltend eine Lichtfalle (2) sowie mindestens eine mit der Lichtfalle (2) gekoppelte Solarzelle (5), wobei die Lichtfalle (2) an der dem Sonnenlicht zugewandten Seite mindestens eine Lichteintrittsfläche zur Einkopplung von Sonnenlicht (1) in die Lichtfalle (2) aufweist, sowie mindestens eine Vorrichtung zur diffusen Reflexion oder Streuung des in die Lichtfalle eingekoppelten Sonnenlichts und mindestens eine das reflektierte und/oder gestreute Sonnenlicht reflektierende Struktur, die einen Austritt des reflektierten und/oder gestreuten Sonnenlichts im wesentlichen verhindern, enthält, **dadurch gekennzeichnet, dass** an der Lichteintrittsfläche der Lichtfalle mindestens eine winkelselektive photonische Struktur (3) angeordnet ist, die eine Einkopplung von Licht innerhalb eines definierten Raumwinkels erlaubt und das restliche Licht reflektiert.

2. Photovoltaik-Vorrichtung nach Anspruch 1, **dadurch gekennzeichnet, dass** die mindestens eine Vorrichtung zur diffusen Reflexion oder Streuung ein diffuser Reflektor ist, der zumindest an der dem Sonnenlicht abgewandten Seite der Lichtfalle angeordnet ist.

3. Photovoltaik-Vorrichtung nach einem der vorhergehenden Ansprüche, **dadurch gekennzeichnet, dass** die mindestens eine Vorrichtung zur diffusen Reflexion aus lichtstreuenden Elementen besteht, die in der Lichtfalle angeordnet sind.

4. Photovoltaik-Vorrichtung nach einem der vorhergehenden Ansprüche, **dadurch gekennzeichnet, dass** der Raumwinkel so gewählt wird, dass das direkte Sonnenlicht für den im Wesentlichen gesamten Sonnenlauf eingekoppelt wird, insbesondere in Kombination mit einer zumindest teilweisen Nachführung der Photovoltaikvorrichtung nach dem Sonnenlauf.

5. Photovoltaik-Vorrichtung nach einem der vorhergehenden Ansprüche, **dadurch gekennzeichnet, dass** der Raumwinkel dem Raumwinkel entspricht, unter dem die Sonne auf der Erde sichtbar ist.

6. Photovoltaik-Vorrichtung nach einem der vorhergehenden Ansprüche, **dadurch gekennzeichnet, dass** an der dem Sonnenlicht abgewandten Fläche, an der dem Sonnenlicht zugewandten Fläche und/oder an den seitlichen Flächen der Lichtfalle (2) zumindest bereichsweise Solarzellen angeordnet sind.

7. Photovoltaik-Vorrichtung nach dem vorhergehenden Anspruch, **dadurch gekennzeichnet, dass** in den Bereichen der Flächen der Lichtfalle (2), in denen keine Solarzellen angeordnet sind, die Reflektoren, insbesondere Lambertsche Reflektoren, oder lichtstreuenden Elemente zumindest bereichsweise angeordnet sind.

8. Photovoltaik-Vorrichtung nach einem der vorhergehenden Ansprüche, **dadurch gekennzeichnet, dass** die Reflektoren und lichtstreuenden Elemente in Form von Beschichtungen realisiert sind.

9. Photovoltaik-Vorrichtung nach einem der vorhergehenden Ansprüche,
**dadurch gekennzeichnet, dass** die mindestens eine Solarzelle eine Dünnschicht-Solarzelle ist.

10. Photovoltaik-Vorrichtung nach einem der vorhergehenden Ansprüche,
**dadurch gekennzeichnet, dass** die mindestens eine Solarzelle eine Rückseitenkontaktierung aufweist.

11. Photovoltaik-Vorrichtung nach einem der vorhergehenden Ansprüche,
**dadurch gekennzeichnet, dass** die Oberfläche der mindestens einen Solarzelle gleich oder kleiner als die seitlichen Flächen der Lichtfalle (2) sind.

12. Photovoltaik-Vorrichtung nach einem der vorhergehenden Ansprüche,
**dadurch gekennzeichnet, dass** die Lichtfalle mindestens zwei Solarzellen aus Halbleitermaterialien mit unterschiedlichen Bandabständen aufweist.

13. Photovoltaik-Vorrichtung nach dem vorhergehenden Anspruch,
**dadurch gekennzeichnet, dass** die mit unterschiedlichen Bandabständen angeordneten Solarzellen in Bezug auf ihre Bandlücke so dimensioniert sind, dass alle Solarzellen den gleichen Strom liefern.

14. Photovoltaik-Vorrichtung nach einem der vorhergehenden Ansprüche,
**dadurch gekennzeichnet, dass** die mindestens eine Solarzelle mit einer spektral selektiven Struktur versehen ist, die zumindest einen Teil des für diese Solarzelle verwertbaren Spektralbereiches des einfallenden Lichtes passieren lässt und einen Teil der anderen Spektralbereiche reflektiert.

15. Photovoltaik-Vorrichtung nach einem der vorhergehenden Ansprüche,
**dadurch gekennzeichnet, dass** die Lichtfalle (2) an der dem Sonnenlicht abgewandten Fläche eine zumindest bereichsweise Solarzellen aufweisende und sägezahn- oder balkenartige Strukturierung besitzt.

16. Photovoltaik-Vorrichtung nach einem der vorhergehenden Ansprüche,
**dadurch gekennzeichnet, dass** die Lichtfalle (2) dem Sonnenlicht um eine oder zwei Achsen nachführbar ist.

17. Photovoltaik-Vorrichtung nach einem der vorhergehenden Ansprüche,
**dadurch gekennzeichnet, dass** die Lichtfalle (2) stationär ist.

18. Photovoltaik-Vorrichtung nach einem der vorhergehenden Ansprüche,
**dadurch gekennzeichnet, dass** die Lichtfalle (2) aus Glas und/oder einem transparenten Kunststoff besteht.

19. Verwendung der Photovoltaik-Vorrichtung nach einem der vorhergehenden Ansprüche zur Umwandlung von Sonnenenergie in elektrische Energie.

**Claims**

1. Photovoltaic device for the direct conversion of solar energy into electrical energy, containing a light trap (2) and at least one solar cell (5) coupled to the light trap (2), wherein the light trap (2) has at least one light entry surface on the side facing towards the sunlight for coupling sunlight (1) into the light trap (2), and has at least one device for the diffuse reflection or scattering of the sunlight coupled into the light trap and at least one structure reflecting the reflected and/or scattered sunlight, said structure substantially preventing the reflected and/or scattered sunlight from leaving,
**characterised in that** at least one angle-selective, photonic structure (3) is arranged on the light entry surface of the light trap, said structure enabling coupling of light within a defined spatial angle and reflecting the remaining light.

2. Photovoltaic device according to claim 1,
**characterised in that** the at least one device for the diffuse reflection or scattering is a diffuse reflector which is arranged at least on the side of the light trap facing away from the sunlight.

3. Photovoltaic device according to one of the preceding claims,
**characterised in that** the at least one device for diffuse reflection consists of light-scattering elements that are arranged in the light trap.

4. Photovoltaic device according to one of the preceding claims,
**characterised in that** the spatial angle is chosen in such a way that the direct sunlight is coupled in for substantially the entire solar run, in particular in combination with an at least partial updating of the photovoltaic device in accordance with the solar run.

5. Photovoltaic device according to one of the preceding claims,
**characterised in that** the spatial angle corresponds to the spatial angle at which the sun is visible on earth.

**6.** Photovoltaic device according to one of the preceding claims,
**characterised in that** solar cells are arranged at least in regions on the surface facing away from the sunlight, on the surface facing towards the sunlight and/or on the lateral surfaces of the light trap (2).

**7.** Photovoltaic device according to the preceding claim,
**characterised in that** the reflectors, in particular Lambertian reflectors, or light-scattering elements, are arranged at least in regions in the regions of the surfaces of the light trap (2) in which no solar cells are arranged.

**8.** Photovoltaic device according to one of the preceding claims,
**characterised in that** the reflectors and light-scattering elements are implemented in the form of coatings.

**9.** Photovoltaic device according to one of the preceding claims,
**characterised in that** the at least one solar cell is a thin-layer solar cell.

**10.** Photovoltaic device according to one of the preceding claims,
**characterised in that** the at least one solar cell has rear side contacting.

**11.** Photovoltaic device according to one of the preceding claims,
**characterised in that** the surface of the at least one solar cell is equal to or smaller than the lateral surfaces of the light trap (2).

**12.** Photovoltaic device according to one of the preceding claims,
**characterised in that** the light trap has at least two solar cells made from semiconductive materials with different band gaps.

**13.** Photovoltaic device according to the preceding claim,
**characterised in that** the solar cells arranged with different band gaps are dimensioned with respect to their band gap in such a way that all solar cells provide the same current.

**14.** Photovoltaic device according to one of the preceding claims,
**characterised in that** the at least one solar cell is provided with a spectrally selective structure which allows at least one part of the spectral range of the incident light that can be used for this solar cell to pass, and which reflects one part of the other spectral ranges.

**15.** Photovoltaic device according to one of the preceding claims,
**characterised in that** the light trap (2) has, on the surface facing away from the sunlight, a structure that has solar cells at least in regions and is sawtooth or beam-shaped.

**16.** Photovoltaic device according to one of the preceding claims,
**characterised in that** the light trap (2) is able to track the sunlight around one or two axes.

**17.** Photovoltaic device according to one of the preceding claims,
**characterised in that** the light trap (2) is stationary.

**18.** Photovoltaic device according to one of the preceding claims,
**characterised in that** the light trap (2) consists of glass and/or a transparent plastic.

**19.** Use of the photovoltaic device according to one of the preceding claims for the conversion of solar energy into electrical energy.

**Revendications**

**1.** Dispositif photovoltaïque pour la transformation directe de l'énergie solaire en énergie électrique, contenant un piège de lumière (2), ainsi qu'au moins une cellule solaire (5) couplée au piège de lumière (2), ledit piège de lumière (2), sur le côté orienté vers la lumière solaire, comportant au moins une surface d'entrée de la lumière pour l'injection de la lumière solaire (1) dans le piège de lumière (2), et contient au moins un dispositif pour la réflexion ou dispersion diffuses de la lumière solaire injectée dans le piège de lumière, et au moins une structure qui réfléchit la lumière solaire réfléchie et/ou dispersée et qui empêche sensiblement une sortie de la lumière solaire réfléchie et/ou dispersée,
**caractérisé en ce que** sur la surface d'entrée de la lumière du piège de lumière est disposée au moins une structure (3) photonique à angle sélectif qui permet une injection de la lumière à l'intérieur d'un angle solide défini et réfléchit la lumière restante.

**2.** Dispositif photovoltaïque selon la revendication 1,
**caractérisé en ce que** ledit au moins un dispositif pour la réflexion ou dispersion diffuses est un réflecteur diffus qui est disposé sur le piège de lumière, au moins sur le côté détourné de la lumière solaire de celui-ci.

**3.** Dispositif photovoltaïque selon l'une quelconque des revendications précédentes, **caractérisé en ce que** ledit au moins un dispositif pour la réflexion diffuse est constitué d'éléments dispersant la lumière, lesquels sont disposés dans le piège de lumière.

4. Dispositif photovoltaïque selon l'une quelconque des revendications précédentes, **caractérisé en ce que** l'angle solide est choisi de telle sorte que la lumière solaire directe est injectée pour la course sensiblement complète du soleil, en particulier en combinaison avec un guidage au moins partiel du dispositif photovoltaïque en suivant la course du soleil.

5. Dispositif photovoltaïque selon l'une quelconque des revendications précédentes, **caractérisé en ce que** l'angle solide correspond à l'angle solide selon lequel le soleil est visible sur la terre.

6. Dispositif photovoltaïque selon l'une quelconque des revendications précédentes, **caractérisé en ce que** des cellules solaires sont disposées au moins par zones sur la surface détournée de la lumière solaire, sur la surface orientée vers la lumière solaire et/ou sur les surfaces latérales du piège de lumière (2).

7. Dispositif photovoltaïque selon l'une quelconque des revendications précédentes, **caractérisé en ce que** des réflecteurs, en particulier des réflecteurs de Lambert, ou des éléments dispersant la lumière sont disposés au moins par zones dans les parties des surfaces du piège de lumière (2), dans lesquelles aucune cellule solaire n'est disposée.

8. Dispositif photovoltaïque selon l'une quelconque des revendications précédentes, **caractérisé en ce que** les réflecteurs et les éléments dispersant la lumière sont réalisés sous forme de revêtements.

9. Dispositif photovoltaïque selon l'une quelconque des revendications précédentes, **caractérisé en ce que** ladite au moins une cellule solaire est une cellule solaire à couche mince.

10. Dispositif photovoltaïque selon l'une quelconque des revendications précédentes, **caractérisé en ce que** ladite au moins une cellule solaire comporte un contact arrière.

11. Dispositif photovoltaïque selon l'une quelconque des revendications précédentes, **caractérisé en ce que** la surface de ladite au moins une cellule solaire est égale ou inférieure aux faces latérales du piège de lumière (2).

12. Dispositif photovoltaïque selon l'une quelconque des revendications précédentes, **caractérisé en ce que** le piège de lumière comporte au moins deux cellules solaires en matériaux semi-conducteurs avec des distances différentes entre les bandes.

13. Dispositif photovoltaïque selon l'une quelconque des revendications précédentes, **caractérisé en ce que** les cellules solaires agencées avec des distances différentes entre les bandes sont dimensionnées quant à leur écartement de bandes de telle sorte que toutes les cellules solaires fournissent le même courant.

14. Dispositif photovoltaïque selon l'une quelconque des revendications précédentes, **caractérisé en ce que** ladite au moins une cellule solaire est munie d'une structure à spectre sélectif, qui laisse passer au moins une partie de la zone spectrale, exploitable par ladite cellule solaire, de la lumière incidente et une partie des autres zones spectrales.

15. Dispositif photovoltaïque selon l'une quelconque des revendications précédentes, **caractérisé en ce que** le piège de lumière (2), sur la surface détournée de la lumière solaire, comporte une structuration comportant au moins par zones des cellules solaires et en forme de dents de scie ou de barres.

16. Dispositif photovoltaïque selon l'une quelconque des revendications précédentes, **caractérisé en ce que** le piège de lumière (2) peut être guidé autour d'un ou de deux axes pour suivre la lumière solaire.

17. Dispositif photovoltaïque selon l'une quelconque des revendications précédentes, **caractérisé en ce que** le piège de lumière (2) est stationnaire.

18. Dispositif photovoltaïque selon l'une quelconque des revendications précédentes, **caractérisé en ce que** le piège de lumière (2) est réalisé en verre et/ou dans une matière plastique transparente.

19. Utilisation du dispositif photovoltaïque selon l'une des revendications précédentes pour la transformation de l'énergie solaire en énergie électrique.

Fig. 1:

Fig. 2

Fig. 3

**Fig. 4**

EP 2 227 832 B1

Fig. 5

Fig. 6

EP 2 227 832 B1

Fig. 7

**Fig. 8**

a)

b)

c)

d)

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5291331 A
- US 20030213514 A

**In der Beschreibung aufgeführte Nicht-Patentliteratur**

- **A.G. IMENES ; D.R. MILLS.** *Solar Energy Materials & Solar Cells,* 2004, vol. 19, 84 ff
- **E. YABLONOVITCH.** *J. Opt. Soc. Am.,* 1982, vol. 72, 899